# EUROPEAN PATENT SPECIFICATION

(11) **EP 1 402 630 B1**
(45) Date of publication and mention of the grant of the patent: **21.06.2006**
(21) Application number: 01962734.8
(22) Date of filing: 12.06.2001
(51) Int. Cl.: H03G 3/30

(54) **METHOD AND DEVICE FOR AUTOMATIC GAIN CONTROL**
VERFAHREN UND VORRICHTUNG ZUR AUTOMATISCHEN VERSTÄRKUNGSREGELUNG
METHODE ET DISPOSITIF DE COMMANDE AUTOMATIQUE DE GAIN

(43) Date of publication of application: 31.03.2004
(73) Proprietor: Nokia Corporation, 02150 Espoo (FI)
(72) Inventor: PIIRAINEN, Olli, FIN-90100 Oulu (FI); YLINEN, Juha, FIN-90570 Oulu (FI)
(74) Representative: Eisenführ, Speiser & Partner
(86) International application number: PCT/EP2001/006623
(87) International publication number: WO 2002/101920

(56) References cited:
- EP-A- 0 825 711
- EP-A- 1 093 240
- WO-A-99/34506
- US-A- 5 974 040

## Description

### FIELD OF THE INVENTION

The present invention relates to a method and a device for automatic gain control of a telecommunication receiver, in particular a multi-carrier receiver in a time division multiple access (TDMA) system, wherein a signal is processed during predetermined time slots in the receiver.

### BACKGROUND OF THE INVENTION

In multi-carrier applications, in particular in GSM/EDGE (Global System for Mobile communications/ Enchanged Data Rates for GSM Evolution) multi-carrier systems with enhanced data rates, not using any automatic gain control (AGC) would lead to unwanted receiver sensitivity loss. With respect thereto, it should be added that in case of Enhanced Data Rate (EDGE) and General Packet Radio System (GPRS) applications, this would lead to a throughput degradation as high signal-to-noise ratios (SNRs) are used to achieve higher data rates.

It is also important to compensate errors in the analog part of the automatic gain control circuit of a receiver in a digital channel filter. Without compensation such analog errors affect the selectivity of the digital channel filter so that it is not good enough for multi-carrier applications in which all selectivity must be realized digitally at the baseband.

There are two kinds of automatic gain control (AGC) schemes currently used, here called as "Slow AGC" and "Fast AGC".

In the Slow AGC, the gain is set at the beginning of the time slot, i.e. in the so-called inactive period, and no gain changes during the active period are allowed. The Slow AGC operates at time slot basis in such a way that the gain changes are performed during a guard period, and therefore the operation is more or less predictive as to the expected received signal strength. An advantage of the Slow AGC scheme is that it causes less disturbance for the baseband operations if operated correctly, although it cannot react to any interfering signals occurring during the time slot (e.g. random access channel (RACH) bursts). However, the Slow AGC scheme has a problem that the prediction of the received signal strength can be complicated and in the case of multi-carrier applications it gets even more complicated.

On the other hand, in the Fast AGC, gain steps are allowed during the active period of the time slot. The Fast AGC scheme adjusts the gain according to the measured signal strength. Therefore, it has an advantage that it is able to correctly follow the changes in the received signal strength. A disadvantage of the Fast AGC scheme is that in multi-carrier applications the channel filtering is performed in the digital domain and the imperfections in the automatic gain control disturb the channel filter operations and, thus, it is difficult to achieve adequate stopband attenuation in order to meet the system specifications for such multi-carrier applications.

Examples of gain adjustment in time slots are disclosed in EP-A-1 093 240 and WO-A-99/34506.

It has been found, that the current automatic gain control systems are not good enough in particular for multi-carrier applications.

### SUMMARY OF THE INVENTION

Accordingly, it is an object of the present invention to provide a method and a device for automatic gain control, which are convenient in particular for multi-carrier applications and overcome the above-mentioned problems.

In order to achieve the above and other objects, according to a first aspect of the present invention, there is provided a method for automatic gain control of a telecommunication receiver, in particular a multi-carrier receiver in a time division multiple access system, wherein the signal is processed in the receiver during predetermined time slots, characterized in that the gain of said signal is allowed to be increased between said time slots and to be decreased during an actual time slot.

In accordance with a second aspect of the present invention, there is also provided a device for automatic gain control of a telecommunication receiver, in particular a multi-carrier receiver in a time division multiple access system, comprising gain changing means for change the gain of a signal to be processed during predetermined time slots in the receiver, characterized in that said gain change means is provided for increasing the gain between said time slots and decreasing the gain during an actual time slot.

The present invention provides a Fast AGC control which is efficient and convenient in particular for a multi-carrier receiver to compensate errors in the analogue part of the automatic gain control circuit of the receiver in the digital channel filter, and which further causes minor impacts to the performance of the receiver only, if there are any at all.

Further advantageous embodiments are defined in the dependent claims.

Preferably, the gain is set to a predetermined maximum value between the time slots whereby the signal is still kept below a parameter "gain limit". Further, the gain can be increased by a multiple of predetermined gain step values.

Further, the gain can be set to a predetermined minimum value during an actual time slot.

In accordance with a further preferred embodiment of the present invention, a change of the gain of the signal to be processed in the receiver is performed during a predetermined gain change time period, wherein further steps of generating interpolated samples by interpolation from samples of said signal are carried out before and/or after said predetermined gain change time period, and samples of said signal occurring around the moment of said gain change are replaced by said interpolated samples.

Accordingly, undesired and inaccurate signal samples, like e.g. signal samples having unwanted transients, can be removed, and such signal samples can be replaced by interpolated samples. If the replacement of signal samples around the moment of the gain change by interpolated samples is done after the wanted signal has been downconverted to 'baseband', the wanted signal does not suffer from the interpolation, but any higher frequency interfering signals are attenuated.

Preferably, samples of the signal occurring just after the gain change are replaced by the interpolated samples.

The gain can be changed as a gain step, wherein the gain step is set to a multiple of predetermined gain step values. In particular, in GSM applications, the gain steps of the variable gain amplifier (VGA) should be set to a multiple of about 6 dB and a preferably 6.02 dB, wherein the impact of the gain changes are compensated with a 'counter' operation in the digital domain.

Further, the possible amount of gain changes should be limited to a predetermined value.

The received signal amplitude can be measured before or after the down-conversion, but the digital shifting operation should be carried out after the down-conversion.

Finally, the gain can be changed during a guard period and/or during an increase of the signal, in particular when the signal is increased along a rising ramp.

### BRIEF DESCRIPTION OF THE DRAWINGS

In the following, the present invention will be described in greater detail based on a preferred embodiment with reference to the accompanying drawings in which
- Fig. 1: shows a schematic block diagram of a fast automatic gain control device,
- Fig. 2: shows a preferred embodiment of a fast automatic gain control structure,
- Fig. 3: is a graph showing the stopband attenuation as a function of time, and
- Fig. 4: is a graph showing the filter response with 0.05 dB gain error.

### DESCRIPTION OF THE PREFERRED EMBODIMENT

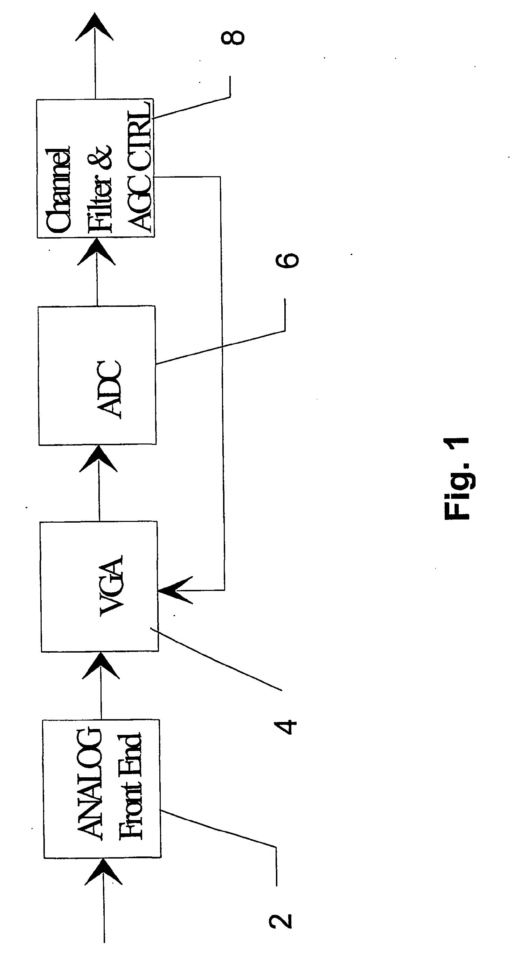

Fig. 1 shows a schematic block diagram of a fast automatic gain control (Fast AGC) device for implementation in a GSM (Global System for Mobile communications) multi-carrier system having enhanced data rates over GSM evolution (EDGE). With the respect thereto, it should be noted here that the principal construction of the Fast automatic gain control device is already used in the prior art in as much as the block diagram is schematically shown in Fig. 1.

The fast automatic gain control device of Fig. 1 comprises an analog front-end circuit 2 that receives an analog input signal. The output of the analog front-end circuit 2 is connected to an input of a variable gain amplifier (VGA) 4. The output of the variable gain amplifier 4 is connected to an input of an analog-to-digital converter (ADC) 6 which converts the analog output signal of the variable gain amplifier 4 into a digital signal. The output of the analog-to-digital-converter 6 is coupled to an input of a channel filter and automatic gain control circuit 8. This circuit 8 includes a digital channel filter portion and an automatic gain control portion and outputs the digital signal. The automatic gain control portion of the circuit 8 controls the variable gain amplifier 4.

The digital channel filter portion in the circuit 8 must fulfil e.g. the following conditions:

### 1. Blocker requirements:

In the GSM specifications a -13 dBm static sine wave blocker is defined (>800 kHz from carrier), and the useful signal level is at level-104 dBm + 3 dB = -101 dB. So, we have a 101 dB - 13 dB = 88 dB stronger blocker than the useful signal. In addition thereto a margin of 7 to 10 dB SNR for the receiver is required. In total a 95 to 98 dB attenuation for the blocker is required.

### 2. Blocking caused by another GSM signal situation:

In real life situation, it can be assumed that a blocking signal is caused by an other mobile. A GSM mobile has an off-band radiation level roughly about -75 dB below the carrier. If a 5 dB margin for a receiver is left, there is a maximum 70 dB higher interfering signal compared to the useful signal, which should be filtered to an insignificant level in order to prevent aliasing. Note that the impact of thermal noise is assumed to be insignificant. This blocker signal can also be a fading signal. Therefore something like 75 to 80 dB requirement for stopband attenuation is required.

The non-idealities of the variable gain amplifier (VGA) cause performance degradation, which can be analysed by checking the impact on the channel filter response. There are several types of non-idealities:
1. Switching transients due to gain change in the VGA.
2. Gain imbalance (the gain steps do not accurately correspond to 6.02 dB).
3. Delay differences in different VGA stages causing a phase distortion.

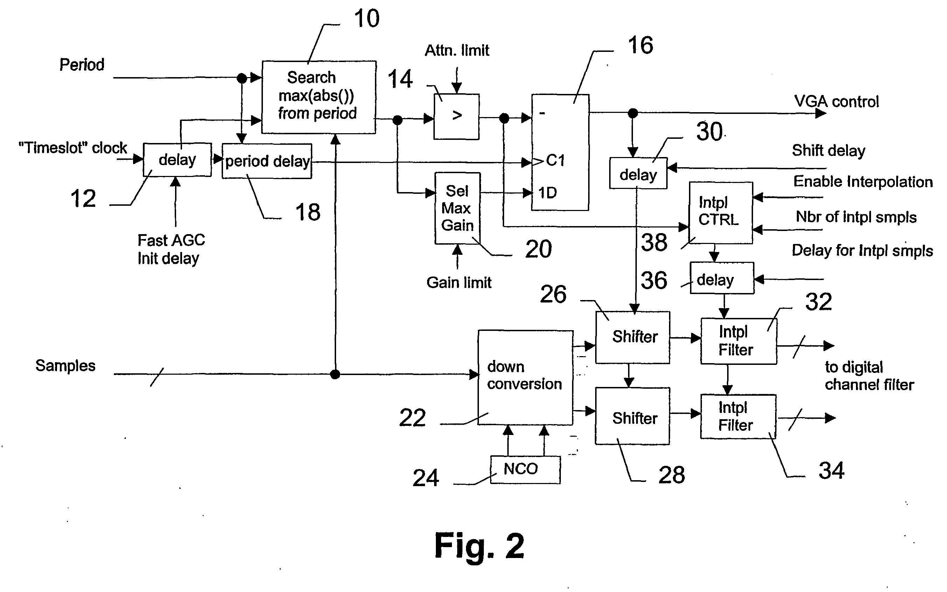

A preferred embodiment of the structure of the automatic gain control portion of the circuit 8 of Fig. 1 is shown in Fig. 2.

The circuit of Fig. 2 comprises an element 10 which receives samples of the signal to be processed and splits them into blocks of size determined by the parameter "period". In addition to the parameter "period" an output signal from a delay element 12 which is controlled by a time slot clock and a parameter "fast AGC initial delay" is further inputted into the element 10. In the element 10, a maximum absolute value from each block of the received samples is searched and outputted.

The output signal from the element 10 is inputted into a limiter 14 which enables an output signal under the condition if the signal from the element 10 is greater than a predetermined limit value "Attn. limit".

The output from the limiter 14 is inputted into a memory unit 16. The memory unit 16 is controlled by an output signal from a delay element 18 which delays the parameter "period" and is controlled by an output signal from the delay element 12. Further, into the "1D" input of the memory unit 16 inputted is an output signal from an element 20 which searches for a maximum gain from the inactive part of the time slot of the output signal from the element 10. The element 20 is controlled by a parameter "gain limit" which causes somewhat like a 'hysteresis' so as to slow down unnecessary stepping. Consequently, under the control of the element 20 the memory unit 16 stores the maximum gain, and during the active period of the time slot of the signal this value can be decreased only. The output signal "VGA control" from the memory unit 16 is provided for controlling the variable gain amplifier of Fig. 1.

Moreover, a down-converter 22 is provided which receives the signal samples, too, and down-converts them from a digital intermediate frequency signal to a baseband signal. The down-converter is controlled by a numerically controlled oscillator 24. The downconverted output signal from the down-converter 22 is transferred to first and second shifters 26 and 28. These shifters 26, 28 shift the signal to the right or to the left, respectively. In practice, this means a multiplication by 2 or division by 2, respectively. Such operation results in a compensation for the 6,02 dB steps. Further, the shifters 26, 28 are controlled by a delay element 30 which is controlled by the "VGA control" outputted from the memory unit 16 and by a parameter "shift delay".

The output signals from the first and second shifters 26 and 28 are fed through first and second interpolation filters 32 and 34 to a digital channel filter (not shown), respectively. The interpolation filters 32, 34 are controlled by a delay element 36 which is controlled by a parameter "delay for interpolation of samples" and an output signal from an interpolation control element 38. The output signal from the limiter 14 and parameters "enable interpolation" and "number of interpolated samples" are inputted into the interpolation control element 38.

The automatic gain control scheme implemented in the structure of Fig. 2 is a Fast AGC. The gain steps are set to a multiple of 6.02 dB, and the impact of gain changes is compensated with a 'counter' operation in the digital domain. The gain in the variable gain amplifier (VGA) 4 of Fig. 1 can be increased by a multiple of 6 dB steps only between timeslots and the value is set to a maximum possible value which still keeps the signal below the parameter "Gain Limit".

During the actual time slot in the GSM/EDGE time multiplexing signal frame, the gain is allowed to be changed only downwards limiting the possible amount of gain changes. The samples just after the gain change are replaced by regenerated samples, which are interpolated from the samples before and/or after a predefined gain change period. The received signal amplitude can be measured before or after the down-conversion, but the digital shifting operation must be replaced after the down-conversion.

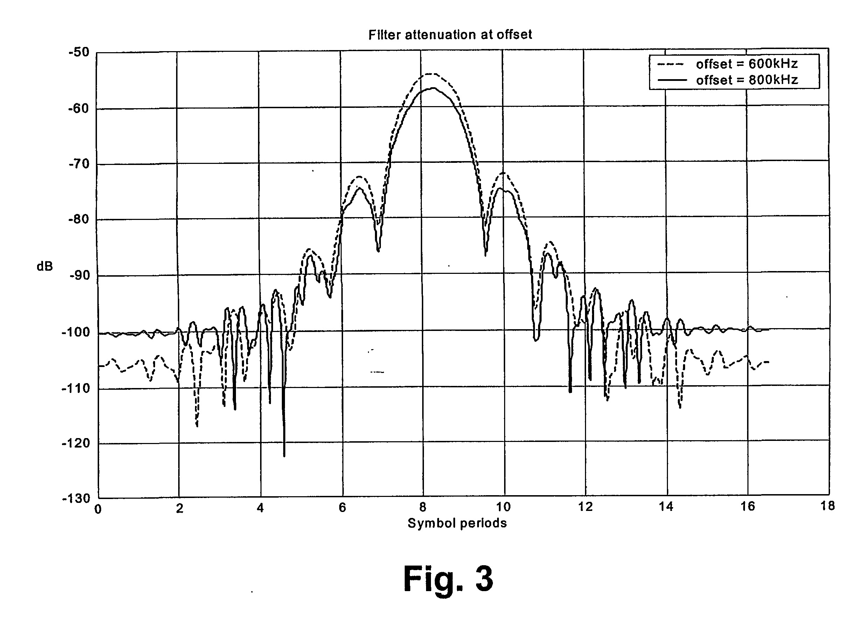

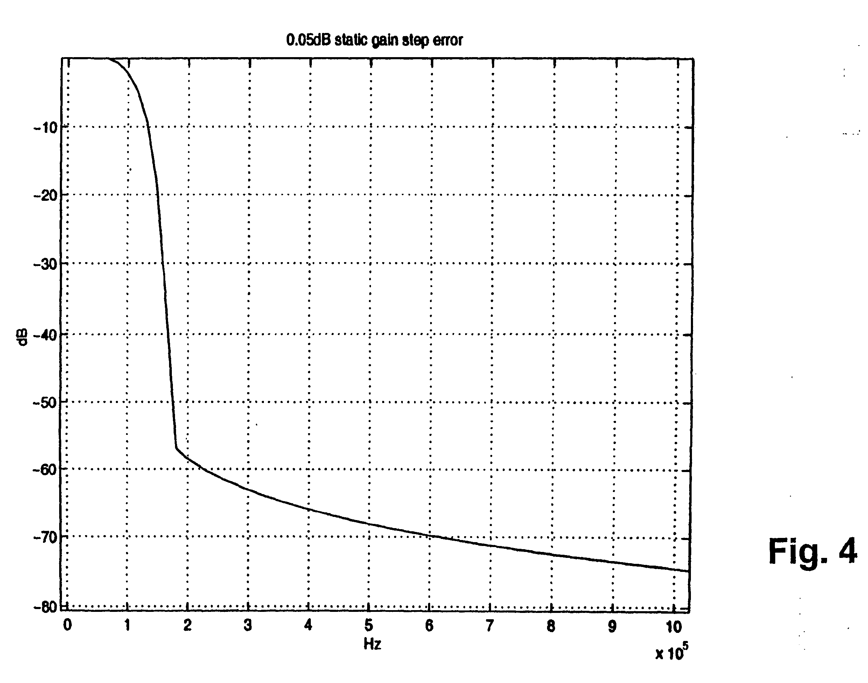

The effects of the fast AGC control structure of Fig. 2 with respect to the above mentioned VGA non-idealities are as follows:
1. Switching transients due to gain change in the VGA:
   The samples with unwanted transients can be removed and these samples can be replaced by interpolated samples. The impact of these transients can be removed without significantly degrading the channel filter performance. Therefore this doesn't cause any problems for a multi-carrier receiver.
2. Gain imbalance (the gain steps do not accurately correspond to 6.02 dB steps):
   A stopband attenuation of about 100 dB is required only in case of a continuous wave (CW) blocker case. As the signal is constant, the parameter "AGC Gain Limit" will force the variable gain amplifier (VGA, cf. circuit 4 of Fig. 1) to stay at maximum attenuation, and therefore no gain steps occur, and the CW blocker causes no problems to the receiver.
   A second case is the blocking caused by another GSM signal with about 75 to 80 dB stopband requirement. Fig. 3 presents the change of channel filter attenuation of 600 kHz and 800 kHz from the carrier as a function of time around the gain change assuming a 0.3 dB gain error. It can be noted that from the peak moment of the gain change to 80 dB attenuation the difference in time is approximately two symbols. Therefore for a blocking caused by another GSM signal it should be a safe operation to change the gain during the guard period or during the rising ramp with no loss in performance. In this way, the AGC gain can be set to a wanted level according to the wanted signal level. In the multi-carrier receiver there could be interfering signals which might arrive at different times than the wanted signal, like a random access channel (RACH) burst, and the level of that signal could be very high causing saturation of the analog-to-digital-converter (ADC, cf. circuit 6 of Fig. 1) if no action in automatic gain control is taken. Therefore it is allowed for the AGC control to add attenuation to the received signal during the received burst.
   Additionally it should be noted that it can be assumed that the 'real life' blocker is another mobile and therefore the change in the received power occurs gradually (power ramp) which gives some possibilities for the AGC design in order to further improve the performance.
   Also it should be noted that according to the graph of Fig. 3 showing the stopband attenuation at fixed points as a function of time the gain error is 0.3 dB and the commercial chip manufacturers claim to achieve accuracy around 0.03 dB. In Fig. 4 a frequency response of the channel filter with AGC step is presented with a 0.05 dB gain error. It could be noted that the response is better compared to the 0.3 dB error values improving the stopband attenuation already to 70 dB.
3. Delay differences in different VGA stages:
   The delay difference causes a phase difference between the signals received with different VGA gains. This phase difference can be seen as an error vector and its amplitude corresponds somewhat to amplitude error simulations. It should be noted that the amplitude of this error vector is depending on the input frequency with the relationship the larger the frequency the larger the error. For example, if the delay difference is 100 ps, the phase error for a 30 MHz input frequency corresponds to about 0.17 dB gain error. The gain steps can be, of course, designed to be much more accurate than 0.3 dB. However, in case the delay difference values are not known, gain steps of 0.3 dB are preferably used.

Although the invention is described above with reference to an example shown in the attached drawings, it is apparent that the invention is not restricted to it, but can vary in many ways within the scope disclosed in the attached claims.

## Claims

1. Method for automatic gain control of a telecommunication receiver, in particular a multi-carrier receiver in a time division multiple access system, wherein the signal is processed in the receiver during predetermined time slots,
**characterized in that** the gain of said signal is allowed to be increased between said time slots and to be decreased during an actual time slot.

2. Method in accordance with claim 1,
**characterized in that** the gain is set to a predetermined maximum value between the time slots.

3. Method in accordance with claim 1 or 2,
**characterized in that** the gain is increased by a multiple of predetermined gain step values.

4. Method in accordance with at least any one of the preceding claims,
**characterized in that** the gain is a set to a predetermined minimum value during an actual time slot.

5. Method in accordance with at least any one of the preceding claims,
**characterized in that** the gain is decreased by a multiple of predetermined gain step values.

6. Method in accordance with at least any one of the preceding claims,
wherein a change of the gain of the signal is performed during a predetermined gain change time period,
**characterized by** the further steps of
generating interpolated samples by interpolation from samples of said signal before and/or after said predetermined gain change time period, and
replacing samples of said signal occurring around the moment of said gain change by said interpolated samples.

7. Method in accordance with claim 6,
**characterized in that** samples of said signal occurring just after said gain change are replaced by said interpolated samples.

8. Method in accordance with at least any one of the preceding claims,
wherein the gain is changed as a gain step.

9. Method in accordance with claim 8,
wherein said gain step is set to a multiple of predetermined gain step values.

10. Method in accordance with at least any one of the preceding claims,
**characterized in that** the gain is adjusted such that the signal is kept below a predetermined limit.

11. Method in accordance with at least any one of the preceding claims,
**characterized in that** the possible amount of gain changes is limited to a predetermined value.

12. Method in accordance with at least any one of the preceding claims,
**characterized in that** the gain is changed during a guard period of said signal.

13. Method in accordance with at least any one of the preceding claims,
**characterized in that** the gain is changed during an increase of said signal, in particular when said signal is increased along a rising ramp.

14. Device for automatic gain control of a telecommunication receiver in particular a multi-carrier receiver in a time division multiple access system, comprising gain change means (10 to 20) for changing the gain of a signal to be processed during predetermined time slots in the receiver,
**characterized in that** said gain change means (10 to 20) is provided for increasing the gain between said time slots and for decreasing the gain during an actual time slot.

15. Device in accordance with claim 14,
**characterized in that** said gain change means (10 to 20) is provided for setting the gain to a predetermined maximum value between said time slots.

16. Device in accordance with claims 14 or 15,
**characterized in that** said gain change means (10 to 20) increases the gain by a multiple of predetermined gain step values.

17. Device in accordance with at least any one of claims 14 to 16,
**characterized in that** said gain change means (10 to 20) is provided for setting the gain to a predetermined minimum value during an actual time slot.

18. Device in accordance with at least any one of claims 14 to 17,
**characterized in that** said gain change means (10 to 20) decreases the gain by a multiple of predetermined gain step values.

19. Device in accordance with at least any one of claims 14 to 18, wherein the gain change means (10 to 20) performs a gain change of said signal during a predetermined gain change time period,
further **characterized by**
means (32 to 38) for generating interpolated samples by interpolation from samples of said signal before and/or after said predetermined gain change time period, and
means (32, 34) for replacing samples of said signal occurring around the moment of said gain change by said interpolated samples.

20. Device in accordance with claim 19,
**characterized in that** said replacing means replaces samples of said signal occurring just after said gain change by said interpolated samples.

21. Device in accordance with at least any one of claims 14 to 20,
wherein said gain change means performs a gain change as a gain step.

22. Device in accordance with claim 21,
wherein said gain change means sets said gain step to a multiple of predetermined gain step values.

23. Device in accordance with at least any one of claims 14 to 22,
**characterized in that** said gain change means adjusts the gain such that the signal is kept below a predetermined limit.

24. Device in accordance with at least any one of claims 14 to 23,
**characterized in that** said gain change means limits the possible amount of gain changes to a predetermined value.

25. Device in accordance with at least any one of claims 14 to 24,
**characterized in that** said gain change means changes the gain during a guard period of said signal.

26. Device in accordance with at least any one of claims 14 to 25,
**characterized in that** said gain change means changes the gain during an increase of said signal, in particular when said signal is increased along a rising ramp.

## Patentansprüche

1. Verfahren zur automatischen Verstärkungsregelung eines Telekommunikationsempfängers, insbesondere eines Mehrfachträgerempfängers in einem Zeitteilungsmehrfachzugriffsystem, bei welchem das Signal im Empfänger während vorbestimmter Zeitschlitze verarbeitet wird,
**dadurch gekennzeichnet, dass** die Verstärkung des Signals zwischen den Zeitschlitzen erhöht und während eines aktuellen Zeitschlitzes verringert werden kann.

2. Verfahren nach Anspruch 1,
**dadurch gekennzeichnet, dass** die Verstärkung auf einem vorbestimmten Maximalwert zwischen den Zeitschlitzen eingestellt wird.

3. Verfahren nach Anspruch 1 oder 2,
**dadurch gekennzeichnet, dass** die Verstärkung um ein Mehrfaches von vorbestimmten Verstärkungsstufenwerten erhöht wird.

4. Verfahren nach mindestens einem der vorangegangenen Ansprüche,
**dadurch gekennzeichnet, dass** die Verstärkung auf einen vorbestimmten Minimalwert während eines aktuellen Zeitschlitzes eingestellt wird.

5. Verfahren nach mindestens einem der vorangegangenen Ansprüche,
**dadurch gekennzeichnet, dass** die Verstärkung um ein Mehrfaches von vorbestimmten Verstärkungsstufenwerten verringert wird.

6. Verfahren nach mindestens einem der vorangegangenen Ansprüche,
bei welchem eine Änderung der Verstärkung des Signals während eines vorbestimmten Verstärkungsänderungszeitintervalls durchgeführt wird,
**gekennzeichnet durch** die weiteren Schritte,
interpolierte Abtastwerte **durch** Interpolation aus Abtastwerten des Signals vor und/oder nach dem vorbestimmten Verstärkungsänderungszeitintervall zu erzeugen und
um den Zeitpunkt der Verstärkungsänderung herum auftretende Abtastwerte des Signals **durch** die interpolierten Abtastwerte zu ersetzen.

7. Verfahren nach Anspruch 6,
**dadurch gekennzeichnet, dass** die kurz nach der Verstärkungsänderung auftretenden Abtastwerte des Signals durch die interpolierten Abtastwerte ersetzt werden.

8. Verfahren nach mindestens einem der vorangegangenen Ansprüche,
bei welchem die Verstärkung als Verstärkungsstufe geändert wird.

9. Verfahren nach Anspruch 8,
bei welchem die Verstärkungsstufe auf eine Vielzahl von vorbestimmten Verstärkungsstufenwerten eingestellt wird.

10. Verfahren nach mindestens einem der vorangegangenen Ansprüche,
**dadurch gekennzeichnet, dass** die Verstärkung so eingestellt wird, dass das Signal unterhalb einer vorbestimmten Grenze gehalten wird.

11. Verfahren nach mindestens einem der vorangegangenen Ansprüche,
**dadurch gekennzeichnet, dass** der mögliche Betrag von Verstärkungsänderungen auf einen vorbestimmten Wert begrenzt wird.

12. Verfahren nach mindestens einem der vorangegangenen Ansprüche,
**dadurch gekennzeichnet, dass** die Verstärkung während eines Sicherheitsintervalls des Signals geändert wird.

13. Verfahren nach mindestens einem der vorangegangenen Ansprüche,
**dadurch gekennzeichnet, dass** die Verstärkung während einer Erhöhung des Signals, insbesondere wenn das Signal entlang einer ansteigenden Rampe angehoben wird, geändert wird.

14. Vorrichtung zur automatischen Verstärkungsregelung eines Telekommunikationsempfängers, insbesondere eines Mehrfachträgerempfängers in einem Zeitteilungsmehrfachzugriffsystem, mit einer Verstärkungsänderungseinrichtung (10 bis 20) zur Veränderung der Verstärkung eines während vorbestimmter Zeitschlitze im Empfänger zu verarbeitenden Signals,
**dadurch gekennzeichnet, dass** die Verstärkungsänderungseinrichtung (10 bis 20) für eine Erhöhung der Verstärkung zwischen den Zeitschlitzen und für eine Verringerung der Verstärkung während eines aktuellen Zeitschlitzes vorgesehen ist.

15. Vorrichtung nach Anspruch 14,
**dadurch gekennzeichnet, dass** die Verstärkungsänderungseinrichtung (10 bis 20) zum Einstellen der Verstärkung auf einen vorbestimmten Maximalwert zwischen den Zeitschlitzen vorgesehen ist.

16. Vorrichtung nach Anspruch 14 oder 15,
**dadurch gekennzeichnet, dass** die Verstärkungsänderungseinrichtung (10 bis 20) die Verstärkung um ein Mehrfaches von vorbestimmten Verstärkungsstufenwerten erhöht.

17. Vorrichtung nach mindestens einem der Ansprüche 14 bis 16,
**dadurch gekennzeichnet, dass** die Verstärkungsänderungseinrichtung (10 bis 20) zum Einstellen der Verstärkung auf einen vorbestimmten Minimalwert während eines aktuellen Zeitschlitzes vorgesehen ist.

18. Vorrichtung nach mindestens einem der Ansprüche 14 bis 17,
**dadurch gekennzeichnet, dass** die Verstärkungsänderungseinrichtung (10 bis 20) die Verstärkung um ein Vielfaches von vorbestimmten Verstärkungsstufenwerten verringert.

19. Vorrichtung nach mindestens einem der Ansprüche 14 bis 18,
bei welcher die Verstärkungsänderungseinrichtung (10 bis 20) eine Verstärkungsänderung des Signals während eines vorbestimmten Verstärkungsänderungszeitintervalls durchführt,
ferner **gekennzeichnet durch**,
eine Einrichtung (32 bis 38) zur Erzeugung von interpolierten Abtastwerten **durch** Interpolation aus Abtastwerten des Signals vor und/oder nach dem vorbestimmten Verstärkungsänderungszeitintervall und
eine Einrichtung (32, 34) zum Austauschen von um den Zeitpunkt der Verstärkungsänderung herum auftretenden Abtastwerten des Signals **durch** die interpolierten Abtastwerte.

20. Vorrichtung nach Anspruch 19,
**dadurch gekennzeichnet, dass** die Austauscheinrichtung kurz nach der Verstärkungsänderung auftretende Abtastwerte des Signals durch die interpolierten Abtastwerte ersetzt.

21. Vorrichtung nach mindestens einem der Ansprüche 14 bis 20,
bei welcher die Verstärkungsänderungseinrichtung eine Verstärkungsänderung als Verstärkungsstufe durchführt.

22. Vorrichtung nach Anspruch 21,
bei welcher die Verstärkungsänderungseinrichtung die Verstärkungsstufe auf eine Mehrzahl von vorbestimmten Verstärkungsstufenwerten einstellt.

23. Vorrichtung nach mindestens einem der Ansprüche 14 bis 22,
**dadurch gekennzeichnet, dass** die Verstärkungsänderungseinrichtung die Verstärkung so einstellt, dass das Signal unterhalb einer vorbestimmten Grenze gehalten wird.

24. Vorrichtung nach mindestens einem der Ansprüche 14 bis 23,
**dadurch gekennzeichnet, dass** die Verstärkungsänderungseinrichtung den möglichen Betrag der Verstärkungsänderungen auf einen vorbestimmten Wert begrenzt.

25. Vorrichtung nach mindestens einem der Ansprüche 14 bis 24,
**dadurch gekennzeichnet, dass** die Verstärkungsänderungseinrichtung die Verstärkung während eines Sicherheitsintervalls des Signals ändert.

26. Vorrichtung nach mindestens einem der Ansprüche 14 bis 25,
**dadurch gekennzeichnet, dass** die Verstärkungsänderungseinrichtung die Verstärkung während einer Erhöhung des Signals, insbesondere wenn das Signal entlang einer ansteigenden Rampe angehoben wird, verändert.

## Revendications

1. Méthode de commande automatique de gain d'un récepteur de télécommunication, en particulier un récepteur à porteuses multiples dans un système d'accès multiple par répartition dans le temps, dans lequel le signal est traité dans le récepteur durant des tranches de temps prédéterminées,
**caractérisée en ce que** le gain dudit signal a la possibilité d'augmenter entre lesdites tranches de temps, et de diminuer durant une tranche de temps en cours.

2. Méthode selon la revendication 1,
**caractérisée en ce que** le gain est défini à une valeur maximum prédéterminée entre les tranches de temps.

3. Méthode selon la revendication 1 ou 2,
**caractérisée en ce que** le gain est augmenté par un multiple de valeurs d'échelon de gain prédéterminées.

4. Méthode selon au moins l'une quelconque des revendications précédentes,
**caractérisée en ce que** le gain est défini à une valeur minimum prédéterminée durant une tranche de temps en cours.

5. Méthode selon au moins l'une quelconque des revendications précédentes,
**caractérisée en ce que** le gain est réduit par un multiple de valeurs d'échelon de gain prédéterminées.

6. Méthode selon au moins l'une quelconque des revendications précédentes,
dans laquelle une modification de gain du signal est accomplie durant une période de temps de modification de gain prédéterminée,
**caractérisée en outre par** les étapes consistant à :
créer des échantillons interpolés par une interpolation à partir d'échantillons dudit signal se produisant avant et / ou après ladite période de temps de modification de gain prédéterminée ; et
remplacer les échantillons dudit signal se produisant autour du moment de ladite modification de gain par lesdits échantillons interpolés.

7. Méthode selon la revendication 6,
**caractérisée en ce que** des échantillons dudit signal se produisant juste après ladite modification de gain sont remplacés par lesdits échantillons interpolés.

8. Méthode selon au moins l'une quelconque des revendications précédentes,
**caractérisée en ce que** le gain se modifie sous la forme d'un échelon de gain.

9. Méthode selon la revendication 8,
dans laquelle ledit échelon de gain est défini à un multiple de valeurs d'échelon de gain prédéterminées.

10. Méthode selon au moins l'une quelconque des revendications précédentes,
**caractérisée en ce que** le gain est ajusté de telle sorte que le signal se maintienne en dessous d'une valeur limite prédéterminée.

11. Méthode selon au moins l'une quelconque des revendications précédentes,
**caractérisée en ce que** la quantité possible de modification de gain est limitée à une valeur prédéterminée.

12. Méthode selon au moins l'une quelconque des revendications précédentes,
**caractérisée en ce que** le gain est modifié durant une période de garde dudit signal.

13. Méthode selon au moins l'une quelconque des revendications précédentes,
**caractérisée en ce que** le gain est modifié durant une augmentation dudit signal, en particulier lorsque ledit signal augmente en suivant une pente montante.

14. Dispositif de commande automatique de gain d'un récepteur de télécommunication, en particulier un récepteur à porteuses multiples dans un système d'accès multiple par répartition dans le temps, comprenant des moyens de modification de gain (10 à 20) pour modifier le gain d'un signal devant être traité dans le récepteur durant des tranches de temps prédéterminées,
**caractérisé en ce que** lesdits moyens de modification de gain (10 à 20) sont prévus pour faire augmenter le gain entre lesdites tranches de temps et pour faire diminuer le gain durant une tranche de temps en cours.

15. Dispositif selon la revendication 14,
**caractérisé en ce que** lesdits moyens de modification de gain (10 à 20) sont prévus pour définir le gain à une valeur maximale prédéterminée entre lesdites tranches de temps.

16. Dispositif selon les revendications 14 ou 15,
**caractérisé en ce que** lesdits moyens de modification de gain (10 à 20) augmentent le gain par un multiple de valeurs d'échelon de gain prédéterminées.

17. Dispositif selon au moins l'une quelconque des revendications 14 à 16,
**caractérisé en ce que** lesdits moyens de modification de gain (10 à 20) sont prévus pour définir le gain à une valeur maximale prédéterminée entre lesdites tranches de temps.

18. Dispositif selon au moins l'une quelconque des revendications 14 à 17,
**caractérisé en ce que** lesdits moyens de modification de gain (10 à 20) diminuent le gain par un multiple de valeurs d'échelon de gain prédéterminées.

19. Dispositif selon au moins l'une quelconque des revendications 14 à 18, dans lequel les moyens de modification de gain (10 à 20) accomplissent une modification de gain dudit signal pendant une période de temps de changement de gain prédéterminée,
**caractérisé en outre par** :
des moyens (32 à 38) pour créer des échantillons interpolés par une interpolation à partir d'échantillons dudit signal se produisant avant et/ou après ladite période de temps de changement de gain prédéterminée, et des moyens (32, 34) pour remplacer les échantillons dudit signal se produisant autour du moment de ladite modification de gain par lesdits échantillons interpolés.

20. Dispositif selon la revendication 19,
**caractérisé en ce que** lesdits moyens de remplacement remplacent des échantillons dudit signal se produisant juste après ladite modification de gain par lesdits échantillons interpolés.

21. Dispositif selon au moins l'une quelconque des revendications 14 à 20,
dans lequel lesdits moyens de modification de gain accomplissent une modification de gain sous la forme d'un échelon de gain.

22. Dispositif selon la revendication 21,
dans lequel lesdits moyens de modification de gain définissent ledit échelon de gain à un multiple de valeurs d'échelon de gain prédéterminées.

23. Dispositif selon au moins l'une quelconque des revendications 14 à 22,
**caractérisé en ce que** lesdits moyens de modification de gain ajustent le gain de telle sorte que le signal se maintienne en dessous d'une valeur limite prédéterminée.

24. Dispositif selon au moins l'une quelconque des revendications 14 à 23,
**caractérisé en ce que** lesdits moyens de modification de gain limitent la quantité possible de modification de gain à une valeur prédéterminée

25. Dispositif selon au moins l'une quelconque des revendications 14 à 24,
**caractérisé en ce que** lesdits moyens de modification de gain modifient le gain durant une période de garde dudit signal.

26. Dispositif selon au moins l'une quelconque des revendications 14 à 25,
**caractérisé en ce que** lesdits moyens de modification de gain modifient le gain durant une augmentation dudit signal, en particulier lorsque ledit signal augmente en suivant une pente montante.
